# EUROPÄISCHE PATENTSCHRIFT

(11) **EP 3 978 299 B1**
(45) Veröffentlichungstag und Bekanntmachung des Hinweises auf die Patenterteilung: **17.04.2024**
(21) Anmeldenummer: 21020398.0
(22) Anmeldetag: 05.08.2021
(51) Int. Cl.: B60L 3/00, B60L 53/60, B60L 53/30, H01M 10/48, B60L 3/04, B60L 53/14, G01R 31/00, G01R 31/40, H01M 10/42, H02J 7/00

(54) **VERFAHREN ZUM BETRIEB EINER FAHRZEUGEXTERNEN LADEVORRICHTUNG ZUM LADEN EINES FAHRZEUGS UND LADEVORRICHTUNG**
METHOD FOR OPERATING A CHARGING DEVICE OUTSIDE OF A VEHICLE FOR CHARGING A VEHICLE AND CHARGING DEVICE
PROCÉDÉ DE FONCTIONNEMENT D'UN DISPOSITIF DE CHARGE EXTERNE DU VÉHICULE PERMETTANT DE CHARGER UN VÉHICULE ET DISPOSITIF DE CHARGE

(30) Priorität: 05.10.2020 DE 102020125943
(43) Veröffentlichungstag der Anmeldung: 06.04.2022
(73) Patentinhaber: Dr.Ing. h.c. F. Porsche Aktiengesellschaft, 70435 Stuttgart (DE)
(72) Erfinder: Heyne, Raoul, 75446 Wiernsheim (DE); Jankovic, Marija, 70565 Stuttgart (DE)

(56) Entgegenhaltungen:
- EP-A1- 3 392 074
- EP-A2- 2 505 415
- EP-A2- 3 243 689
- DE-A1-102009 034 887
- DE-A1-102017 005 306
- US-A1- 2014 217 971

## Beschreibung

Die Erfindung betrifft ein Verfahren zum Betrieb einer fahrzeugexternen Ladevorrichtung zum Laden eines Elektro- oder Hybridfahrzeugs.

Um eine Sichere Funktion der Ladevorrichtung zu gewährleisten, ist es notwendig, das Ladekabel der Ladevorrichtung, also das Kabel, mit welchem das zu ladende Fahrzeug an der Ladevorrichtung angeschlossen wird, auf seine Funktionsfähigkeit und insbesondere seine elektrische Isolierung zu prüfen. Dies geschieht üblicherweise mit sogenannten Isolationswächtern. Isolationswächter funktionieren hierbei allerdings nur sicher, wenn sie korrekt angeschlossen sind. Aus dem Stand der Technik sind Isolationswächter bekannt, welche selbstständig ihren korrekten Anschluss überprüfen können. Dies geschieht über eine Widerstandsprüfung zwischen zwei elektrischen Leitungen an die sie angeschlossen sind. Üblicherweise werden Isolationswächter an einer Leistungselektronik der Ladevorrichtung angeschlossen, wodurch bei der Widerstandsmessung ein Widerstand von maximal 4 MOhm gemessen wird. Liegt der Widerstand darüber, so kann die Prüfung des Anschlusses nicht durchgeführt werden.

Wenn die elektrische Isolation des Ladekabels überwacht werden soll, so geschieht dies üblicherweise während eines Ladevorgangs. Dies ist dem geschuldet, dass zwischen dem Isolationswächter und dem Ladekabel ein Schütz angeordnet ist. Dieses ist nur während des Ladevorganges in einem geschlossenen Schaltzustand, so dass eine elektrische Verbindung zwischen der Leistungselektronik, dem Isolationswächter und dem Ladekabel hergestellt ist. Ordnet man den Isolationswächter ladekabelseitig des Schützes an, so wird die Isolation des Ladekabels dennoch nur überwacht, wenn der Schaltzustand des Schützes geschlossen ist. In einem solchen Fall ist der Isolationswächter nicht in der Lage, seinen korrekten Anschluss festzustellen, da das Ladekabel außerhalb des Ladevorganges, also wenn kein Fahrzeug angeschlossen ist, einen Widerstand von deutlich über 4 MOhm aufweist.

Dennoch ist es wünschenswert, die elektrische Isolation des Ladekabels zu überwachen, auch wenn gerade kein Fahrzeug geladen wird. Dies hätte den Vorteil, dass bei einer Beschädigung des Ladekabels die Ladevorrichtung außer Betrieb genommen und einem Fahrzeugführer dies frühzeitig angezeigt werden kann, ohne dass erst bei angeschlossenem Fahrzeug festgestellt wird, dass ein Ladevorgang nicht möglich ist.

US 2014 / 0 217 971 A1 offenbart ein Verfahren zum Betrieb einer fahrzeugexternen Ladevorrichtung nach dem Oberbegriff des Anspruchs 1.

EP 3 243 689 A2 und DE 10 2017 005 306 A1 offenbaren weiteren Stand der Technik.

Vor diesem Hintergrund ist es Aufgabe.der vorliegenden Erfindung, ein Verfahren zur Durchführung eines Ladevorganges einer fahrzeugexternen Ladevorrichtung zum Laden eines Elektro- oder Hybridfahrzeugs zu ermöglichen, welches die erwähnten Nachteile des Standes der Technik nicht aufweist, sondern die Möglichkeit bietet, die elektrische Isolation des Ladekabels auch außerhalb eines Ladevorganges zu überwachen.

Zur Lösung der Aufgabe wird ein Verfahren zum Betrieb einer fahrzeugexternen Ladevorrichtung zum Laden eines Elektro- oder Hybridfahrzeugs vorgeschlagen, wobei ein elektrischer Anschluss eines zwischen einem Schütz der Ladevorrichtung und einem Ladekabel der Ladevorrichtung angeschlossenen Isolationswächters überprüft wird wenn das Schütz in einem geschlossenen Schaltzustand ist und eine elektrische Isolation des Ladekabels von dem Isolationswächter geprüft wird, wenn das Schütz in einem geöffneten Schaltzustand ist. Das erfindungsgemäße Verfahren erlaubt es auf voreilhafte Weise, die Überwachung der elektrischen Isolation des Ladekabels von der Überprüfung des korrekten Anschlusses des Isolationswächters zu trennen und folglich die elektrische Isolation des Ladekabels auch außerhalb von Ladevorgängen sicher zu überwachen.

Ein Schütz im Sinne der vorliegenden Erfindung ist auch als Schaltschütz bekannt und ist ein elektrisch oder elektromagnetisch betätigter Schalter für große elektrische Leistungen. Insbesondere ist ein Schütz im Sinne der vorliegenden Erfindung ein Schalter zum Verbinden bzw. Trennen einer Ladeverbindung zwischen Fahrzeug und Ladevorrichtung.

Gemäß der Erfindung ist vorgesehen, dass von dem Isolationswächter bei geöffnetem Schaltzustand des Schützes die elektrische Isolation der Ladevorrichtung zwischen dem Schütz und einer Leistungselektronik überprüft wird. Die elektrische Isolation der Ladevorrichtung zwischen dem Schütz und der Leistungselektronik ist typischerweise die elektrische Isolation von Stromschienen und/oder elektrischen Leitungen zwischen der Leistungselektronik und dem Schütz. Dazu ist der Isolationswächter vorzugsweise zum einen mit ersten Anschlüssen mit dem Ladekabel verbunden und mit zweiten Anschlüssen mit den Stromschienen und/oder den elektrischen Leitungen zwischen der Leistungselektronik und dem Schütz verbunden.

Dazu ist vorzugsweise vorgesehen, dass ein weiterer elektrischer Anschluss des Isolationswächters zwischen dem Schütz und der Leistungselektronik bei geöffnetem Schaltzustand des Schützes überprüft wird. Die Prüfung des korrekten weiteren elektrischen Anschlusses geschieht vorzugsweise über eine Widerstandsmessung zwischen den elektrischen Leitern und/oder Stromschienen, an die der Isolationswächter mit den zweiten Anschlüssen angeschlossen ist.

Gemäß der vorliegenden Erfindung ist weiter vorgesehen, dass die elektrische Isolation des Ladekabels an ersten Anschlüssen des Isolationswächters geprüft wird, wobei die elektrische Isolation der Ladevorrichtung zwischen dem Schütz und der Leistungselektronik an zweiten Anschlüssen des Isolationswächters geprüft wird, wobei bei geschlossenem Schaltzustand des Schützes Messwerte an den ersten Anschlüssen mit Messwerten an den zweiten Anschlüssen verglichen werden. Damit ist es auf vorteilhafte Weise möglich, Fehlfunktionen beim Ladevorgang zu entdecken und notfalls den Ladevorgang zu beenden. Vorzugsweise werden die Messwerte verglichen, um den korrekten Anschluss bei einem Selbsttest zu bestätigen.

Vorteilhafte Ausgestaltungen und Weiterbildungen der Erfindung sind den Unteransprüchen, sowie der Beschreibung unter Bezugnahme auf die Zeichnungen entnehmbar.

Gemäß einer vorteilhaften Ausgestaltung der vorliegenden Erfindung ist vorgesehen, dass der korrekte Anschluss des Isolationswächters von dem Isolationswächter geprüft wird. Die Implementierung der Prüfung des korrekten Anschlusses des Isolationswächters in den Isolationswächter ermöglicht eine präzise und sichere Aussage über den Anschluss. Die Prüfung des korrekten Anschlusses geschieht über eine Widerstandsmessung zwischen den elektrischen Leitern, an die der Isolationswächter angeschlossen ist. Zur Widerstandsmessung werden die gleichen Anschlüsse des Isolationswächters genutzt, welche ebenfalls zur Überwachung der elektrischen Isolation genutzt werden.

Gemäß einer weiteren vorteilhaften Ausgestaltung der vorliegenden Erfindung ist vorgesehen, dass der Schaltzustand des Schützes von einem, vorzugsweise zwangsgeführten, Hilfskontakt des Schützes über eine Signalleitung an den Isolationswächter übertragen wird. Dies ermöglicht auf vorteilhafte Weise festzustellen, wann der korrekte Anschluss und wann die elektrische Isolation geprüft werden sollen.

Gemäß einer weiteren vorteilhaften Ausgestaltung der vorliegenden Erfindung ist vorgesehen, dass der Schaltzustand des Schützes von einem Steuerrechner der Ladevorrichtung an den Isolationswächter übertragen wird. Der Steuerrechner steuert üblicherweise den Ladevorgang, regelt also auch den Schaltzustand des Schützes. Somit ist es auf vorteilhafte Weise möglich, dem Isolationswächter mitzuteilen, wann der korrekte Anschluss und wann die elektrische Isolation geprüft werden.

Denkbar ist zudem, dass der Isolationswächter eine elektrische Spannung zwischen den elektrischen Leitern des Ladekabels überwacht. Ist der Schaltzustand des Schützes geöffnet, wird also nicht geladen, so liegt keine elektrische Spannung zwischen den Leitern an. Wird das Schütz für einen Ladevorgang geschlossen, so ist eine elektrische Spannung zwischen den Leitern messbar. Der Isolationswächter kann somit erkennen, wann der korrekte Anschluss und wann die elektrische Isolation zu prüfen sind.

Gemäß einer weiteren vorteilhaften Ausgestaltung der vorliegenden Erfindung ist vorgesehen, dass vom Isolationswächter eine elektrische Spannung zwischen elektrischen Leitungen des Ladekabels überwacht wird, wobei vom Isolationswächter vorzugsweise eine weitere elektrische Spannung zwischen elektrischen Leitungen zwischen dem Schütz und der Leistungselektronik überwacht wird. Die elektrische Spannung dient als Erkennung eines Ladevorganges bzw. der Einleitung eines Ladevorganges. Somit kann bei dem Ladevorgang bzw. der Einleitung des Ladevorganges ein Selbsttest durchgeführt werden, da dabei das Schütz geschlossen ist und der Widerstand kleiner als beispielsweise 4 MOhm sein sollte. Liegt der Widerstandswert unter einem Grenzwert, beispielsweise 4 MOhm bei geöffnetem Schütz, so deutet dies auf eine Beschädigung des Ladekabels hin. Dies ermöglicht auf vorteilhafte Weise die Überwachung des Schaltzustandes des Schützes durch den Isolationswächter selbst. Ferner ist es möglich, dass Unstimmigkeiten beim Ladevorgang erkannt werden.

Gemäß einem weiteren vorteilhaften Beispiel der vorliegenden Erfindung ist vorgesehen, dass der elektrische Anschluss des Isolationswächters überprüft und/oder die elektrische Isolation des Ladekabels anhand von Referenzwerten überprüft werden, wobei die Referenzwerte dem Isolationswächter vorzugsweise als Werte-Matrix bereitgestellt werden, wobei die Referenzwerte vorzugsweise bei einem Ladevorgang aktualisiert werden.

Ein weiterer Gegenstand der Erfindung zur Lösung der Eingangs formulierten Aufgabe ist eine Ladevorrichtung gemäss Anspruch 8 zur Durchführung des erfindungsgemäßen Verfahrens.

Gemäß einer weiteren vorteilhaften Ausgestaltung der vorliegenden Erfindung ist vorgesehen, dass der Isolationswächter der Ladevorrichtung zwischen dem Schütz und dem Ladekabel der Ladevorrichtung angeschlossen ist, wobei der Isolationswächter ebenfalls zwischen dem Schütz und der Leistungselektronik der Ladevorrichtung angeschlossen ist.

Alle zuvor offenbarten Einzelheiten, Merkmale und Vorteile beziehen sich sowohl auf das erfindungsgemäße Verfahren, als auch auf die erfindungsgemäße Ladevorrichtung.

Weitere Einzelheiten und Vorteile der Erfindung sollen nachfolgend anhand des in der Zeichnung dargestellten Ausführungsbeispiels erläutert werden. Hierin zeigt:

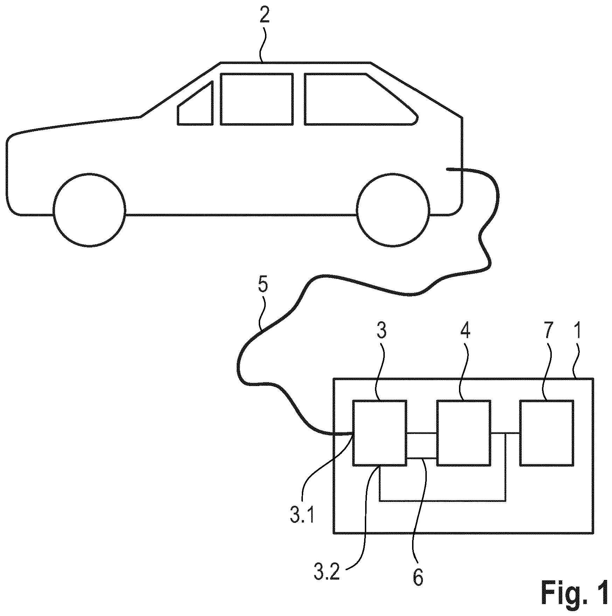

- Fig. 1: illustriert schematisch eine Ladevorrichtung gemäß einer beispielhaften Ausführungsform der vorliegenden Erfindung, welche gemäß einer beispielhaften Ausführungsform der vorliegenden Erfindung betrieben wird.

Fig. 1 illustriert schematisch eine Ladevorrichtung 1 gemäß einer beispielhaften Ausführungsform der vorliegenden Erfindung, welche gemäß einer beispielhaften Ausführungsform der vorliegenden Erfindung betrieben wird. Die Ladevorrichtung 1 ist eine fahrzeugexterne Ladevorrichtung 1 zum Laden eines Fahrzeugs 2 mit elektrischem Antrieb. Das Fahrzeug 2 ist mit einem Ladekabel 5 an der Ladevorrichtung 1 angeschlossen. Zwischen einer Leistungselektronik 7 der Ladevorrichtung 1 und dem Ladekabel 5 ist ein Schütz 4 angeordnet. Das Schütz 4 verbindet die Leistungselektronik 7 bei geschlossenem Schaltzustand elektrisch mit dem Ladekabel 5 und unterbricht die Verbindung zwischen Ladekabel 5 und Leistungselektronik 7 bei geöffnetem Schaltzustand.

Zwischen dem Schütz 4 und dem Ladekabel 5 ist ein Isolationswächter 3 der Ladevorrichtung 1 angeordnet. Der Isolationswächter 3 überwacht die elektrische Isolation von Leitungen an denen er angeschlossen ist. Zum sicheren Laden des Fahrzeugs 2 ist dies unumgänglich. Damit die Isolationsüberwachung korrekt funktioniert, überprüft der Isolationswächter 3 seinen korrekten Anschluss. Dazu führt er eine Widerstandsmessung an den zu überwachenden elektrischen Leitungen durch. Möglich ist dies jedoch nur für Widerstände welche beispielsweise kleiner als 4 MOhm sind.

Wünschenswert ist es, dass die Isolation des Ladekabels 5 auch geprüft werden kann, wenn gerade kein Fahrzeug 2 geladen wird, wenn das Ladekabel 5 also ein offenes Ende und damit einen unendlich hohen Widerstand bietet. Da in einem solchen Fall die Überprüfung des korrekten Anschlusses des Isolationswächters 3 nicht durchgeführt werden kann, wird die Überprüfung des Anschlusses abhängig vom Schaltzustand des Schützes 4 durchgeführt. Ist der Schaltzustand des Schützes 4 geschlossen, findet also gerade ein Ladevorgang statt, so liegt der Widerstand des Ladekabels bei unter z.B. 4 MOhm und der korrekte elektrische Anschluss kann überprüft werden. Ist dies festgestellt, so kann auch zwischen den Ladevorgängen die elektrische Isolation des Ladekabels 5 überwacht werden.

Informationen über den Schaltzustand des Schützes 4 erhält der hier gezeigte Isolationswächter 3 über eine Signalleitung 6, welche einen zwangsgeführten Hilfskontakt des Schützes mit dem Isolationswächter 3 verbindet. Alternativ oder zusätzlich dazu ist es möglich, dass ein Steuerrechner Informationen über den Schaltzustand an den Isolationswächter 3 überträgt.

Vorzugsweise wird vom Isolationswächter 3 eine elektrische Spannung zwischen den Leitern des Ladekabels 5 überwacht. Liegt hier eine Spannung an, so bedeutet dies, dass das Schütz 4 im geschlossenen Schaltzustand ist und der korrekte Anschluss des Isolationswächters 3 geprüft werden kann.

Das Ladekabel 5 ist an ersten Anschlüssen 3.1 des Isolationswächters 3 angeschlossen, bzw. der Isolationswächter 3 ist an den ersten Anschlüssen 3.1 an das Ladekabel 5 angeschlossen. An zweiten Anschlüssen 3.2 sind elektrische Leiter und/oder Stromschienen zwischen dem Schütz 4 und der Leistungselektronik 7 angeschlossen. Über die zweiten Anschlüsse 3.2 überwacht der hier gezeigte Isolationswächter 3 die elektrische Isolierung der elektrischen Leiter und/oder Stromschienen zwischen dem Schütz 4 und der Leistungselektronik 7. Ferner überprüft der hier gezeigte Isolationswächter 3 den korrekten Anschluss der zweiten Anschlüsse 3.2 an die elektrischen Leiter und/oder Stromschienen zwischen dem Schütz 4 und der Leistungselektronik 7. Beides kann bei geschlossenem und geöffnetem Schaltzustand durchgeführt werden.

Um eine korrekte Durchführung des Ladevorganges sicherzustellen, vergleicht der Isolationswächter 3 die an den ersten Anschlüssen 3.1 erhobenen Messwerte mit den an den zweiten Anschlüssen 3.2 erhobenen Messwerten während des Ladevorganges. Unstimmigkeiten, welche auf mögliche Probleme und Defekte schließen lassen. können, können so entdeckt und der Ladevorgang notfalls abgebrochen werden.

### Bezugszeichenliste

- 1: Ladevorrichtung
- 2: Fahrzeug
- 3: Isolationswächter
- 3.1: erste Anschlüsse
- 3.2: zweite Anschlüsse
- 4: Schütz
- 5: Ladekabel
- 6: Signalleitung
- 7: Leistungselektronik

## Patentansprüche

1. Verfahren zum Betrieb einer fahrzeugexternen Ladevorrichtung (1) zum Laden eines Elektro-oder Hybridfahrzeugs, wobei ein elektrischer Anschluss eines zwischen einem Schütz (4) der Ladevorrichtung (1) und einem Ladekabel (5) der Ladevorrichtung (1) angeschlossenen Isolationswächters (3) überprüft wird, wobei eine elektrische Isolation des Ladekabels (5) von dem Isolationswächter (3) geprüft wird, wenn das Schütz (4) in einem geöffneten Schaltzustand ist,
**dadurch gekennzeichnet, dass**
das Ladekabel (5) an ersten Anschlüssen (3.1) des Isolationswächters (3) angeschlossen ist, wobei an zweiten Anschlüssen (3.2) des Isolationswächters (3) elektrische Leiter zwischen dem Schütz (4) und einer Leistungselektronik (7) der Ladevorrichtung (1) angeschlossen sind,
der elektrische Anschluss des Isolationswächters (3) vom Isolationswächter (3) über eine Widerstandsmessung an zu überwachenden elektrischen Leitungen, an die der Isolationswächter (3) mit den zweiten Anschlüssen (3.2) angeschlossen ist, überprüft wird, wenn das Schütz (4) in einem geschlossenen Schaltzustand ist,
von dem Isolationswächter (3) bei geöffnetem Schaltzustand des Schützes (4) die elektrische Isolation der Ladevorrichtung (1) zwischen dem Schütz (4) und der Leistungselektronik (7) überprüft wird,
die elektrische Isolation des Ladekabels (5) an den ersten Anschlüssen (3.1) des Isolationswächters (3) geprüft wird, wobei die elektrische Isolation der Ladevorrichtung (1) zwischen dem Schütz (4) und der Leistungselektronik (7) an den zweiten Anschlüssen (3.2) des Isolationswächters (3) geprüft wird, wobei bei geschlossenem Schaltzustand des Schützes (4) Messwerte an den ersten Anschlüssen (3.1) mit Messwerten an den zweiten Anschlüssen (3.2) verglichen werden.

2. Verfahren nach Anspruch 1, wobei der Schaltzustand des Schützes (4) von einem Hilfskontakt des Schützes (4) über eine Signalleitung (6) an den Isolationswächter (3) übertragen wird.

3. Verfahren nach Anspruch 2, wobei der der Schaltzustand des Schützes (4) von einem zwangsgeführten Hilfskontakt des Schützes (4) über die Signalleitung (6) an den Isolationswächter (3) übertragen wird.

4. Verfahren nach einem der vorhergehenden Ansprüche, wobei der Schaltzustand des Schützes (4) von einem Steuerrechner der Ladevorrichtung (1) an den Isolationswächter (3) übertragen wird.

5. Verfahren nach einem der vorhergehenden Ansprüche, wobei ein weiterer elektrischer Anschluss des Isolationswächters (3) zwischen dem Schütz (4) und der Leistungselektronik (7) bei geöffnetem Schaltzustand des Schützes (4) überprüft wird.

6. Verfahren nach einem der vorhergehenden Ansprüche, wobei vom Isolationswächter (3) eine elektrische Spannung zwischen elektrischen Leitungen des Ladekabels (5) überwacht wird.

7. Verfahren nach Anspruch 6, wobei vom Isolationswächter (3) eine weitere elektrische Spannung zwischen elektrischen Leitungen zwischen dem Schütz (4) und der Leistungselektronik (7) überwacht wird.

8. Ladevorrichtung (1) zum Laden eines Elektro- oder Hybridfahrzeugs, die Ladevorrichtung (1) aufweisend einen Schütz (4), ein Ladekabel (5), einen Isolationswächter (3) und eine Leistungselektronik (7), **dadurch gekennzeichnet, dass** die Ladevorrichtung zur Durchführung eines Verfahrens nach einem der vorhergehenden Ansprüche 1 bis 7 konfiguriert ist, und dass das Ladekabel (5) an ersten Anschlüssen (3.1) des Isolationswächters (3) angeschlossen ist, wobei an zweiten Anschlüssen (3.2) des Isolationswächters (3) elektrische Leiter zwischen dem Schütz (4) und der Leistungselektronik (7) der Ladevorrichtung (1) angeschlossen sind.

9. Ladevorrichtung (1) nach Anspruch 8, wobei der Isolationswächter (3) der Ladevorrichtung (1) zwischen dem Schütz (4) und dem Ladekabel (5) der Ladevorrichtung (1) angeschlossen ist, wobei der Isolationswächter (3) ebenfalls zwischen dem Schütz (4) und der Leistungselektronik (7) der Ladevorrichtung (1) angeschlossen ist.

## Claims

1. A method for operating a vehicle-external charging device (1) for charging an electric or hybrid vehicle, wherein an electrical connection of an insulation monitor (3) connected between a contactor (4) of the charging device (1) and a charging cable (5) of the charging device (1) is checked, wherein an electrical insulation of the charging cable (5) is checked by the insulation monitor (3) when the contactor (4) is in an open switching state,
**characterised in that**
the charging cable (5) is connected to first connections (3.1) of the insulation monitor (3), wherein electrical conductors between the contactor (4) and a power electronics (7) of the charging device (1) are connected to second connections (3.2) of the insulation monitor (3);
when the contactor (4) is in a closed switching state, the electrical connection of the insulation monitor (3) is checked by the insulation monitor (3) by way of a resistance measurement on electrical lines to be monitored, the insulation monitor (3) being connected to said lines via the second connections (3.2),
when the switching state of the contactor (4) is open, the electrical insulation of the charging device (1) between the contactor (4) and the power electronics (7) is checked by the insulation monitor (3),
the electrical insulation of the charging cable (5) is checked at the first connections (3.1) of the insulation monitor (3), wherein the electrical insulation of the charging device (1) between the contactor (4) and the power electronics (7) is checked at the second connections (3.2) of the insulation monitor (3), wherein measured values at the first connections (3.1) are compared with measured values at the second connections (3.2) when the switching state of the contactor (4) is closed.

2. The method according to claim 1, wherein the switching state of the contactor (4) is transmitted from an auxiliary contact of the contactor (4) to the insulation monitor (3) via a signal line (6) .

3. The method according to claim 2, wherein the switching state of the contactor (4) is transmitted from a positively-driven auxiliary contact of the contactor (4) to the insulation monitor (3) via the signal line (6).

4. The method according to any one of the preceding claims, wherein the switching state of the contactor (4) is transmitted from a control computer of the charging device (1) to the insulation monitor (3).

5. The method according to any one of the preceding claims, wherein a further electrical connection of the insulation monitor (3) between the contactor (4) and the power electronics (7) is checked when the switching state of the contactor (4) is open.

6. The method according to any one of the preceding claims, wherein an electrical voltage is monitored by the insulation monitor (3) between electrical lines of the charging cable (5).

7. The method according to claim 6, wherein a further electrical voltage between electrical lines between the contactor (4) and the power electronics (7) is monitored by the insulation monitor (3) .

8. A charging device (1) for charging an electric or hybrid vehicle,
the charging device (1) comprising a contactor (4), a charging cable (5), an insulation monitor (3) and a power electronics (7), **characterised in that** the charging device is configured to carry out a method according to any one of the preceding claims 1 to 7, and that the charging cable (5) is connected to first connections (3.1) of the insulation monitor (3), wherein electrical conductors between the contactor (4) and the power electronics (7) of the charging device (1) are connected to second connections (3.2) of the insulation monitor (3).

9. The charging device (1) according to claim 8, wherein the insulation monitor (3) of the charging device (1) is connected between the contactor (4) and the charging cable (5) of the charging device (1), wherein the insulation monitor (3) is also connected between the contactor (4) and the power electronics (7) of the charging device (1).

## Revendications

1. Procédé pour faire fonctionner un dispositif de charge (1) externe de véhicule destiné à charger un véhicule électrique ou hybride, dans lequel un raccordement électrique d'un dispositif de surveillance d'isolation (3) raccordé entre un contacteur (4) du dispositif de charge (1) et un câble de charge (5) du dispositif de charge (1) est vérifié, dans lequel une isolation électrique du câble de charge (5) est vérifiée par le dispositif de surveillance d'isolation (3) lorsque le contacteur (4) est dans un état de commutation ouvert,
**caractérisé en ce que**
le câble de charge (5) est raccordé aux premiers raccordements (3.1) du dispositif de surveillance d'isolation (3), dans lequel des conducteurs électriques entre le contacteur (4) et une électronique de puissance (7) du dispositif de charge (1) sont raccordés aux deuxièmes raccordements (3.2) du dispositif de surveillance d'isolation '(3) ;
lorsque le contacteur (4) est dans un état de commutation fermé, le raccordement électrique du dispositif de surveillance d'isolation (3) est vérifié par le dispositif de surveillance d'isolation (3) au moyen d'une mesure de résistance sur des lignes électriques à surveiller, le dispositif de surveillance d'isolation (3) étant raccordé auxdites lignes par l'intermédiaire des deuxièmes raccordements (3.2),
lorsque l'état de commutation du contacteur (4) est ouvert, l'isolation électrique du dispositif de charge (1) entre le contacteur (4) et l'électronique de puissance (7) est vérifiée par le dispositif de surveillance d'isolation (3),
l'isolation électrique du câble de charge (5) est vérifiée au niveau des premiers raccordements (3.1) du dispositif de surveillance d'isolation (3), dans lequel l'isolation électrique du dispositif de charge (1) entre le contacteur (4) et l'électronique de puissance (7) est vérifiée au niveau des deuxièmes raccordements (3.2) du dispositif de surveillance d'isolation (3), dans lequel des valeurs mesurées au niveau des premiers raccordements (3.1) sont comparées à des valeurs mesurées au niveau des deuxièmes raccordements (3.2) lorsque l'état de commutation du contacteur (4) est fermé.

2. Procédé selon la revendication 1, dans lequel l'état de commutation du contacteur (4) est transmis d'un contact auxiliaire du contacteur (4) au dispositif de surveillance d'isolation (3) par l'intermédiaire d'une ligne de signal (6).

3. Procédé selon la revendication 2, dans lequel l'état de commutation du contacteur (4) est transmis d'un contact auxiliaire à entraînement positif du contacteur (4) au dispositif de surveillance d'isolation (3) par l'intermédiaire de la ligne de signal (6).

4. Procédé selon l'une quelconque des revendications précédentes, dans lequel l'état de commutation du contacteur (4) est transmis d'un ordinateur de commande du dispositif de charge (1) au dispositif de surveillance d'isolation (3).

5. Procédé selon l'une quelconque des revendications précédentes, dans lequel un raccordement électrique supplémentaire du dispositif de surveillance d'isolation (3) entre le contacteur (4) et l'électronique de puissance (7) est vérifié lorsque l'état de commutation du contacteur (4) est ouvert.

6. Procédé selon l'une quelconque des revendications précédentes, dans lequel une tension électrique est surveillée par le dispositif de surveillance d'isolation (3) entre des lignes électriques du câble de charge (5).

7. Procédé selon la revendication 6, dans lequel une tension électrique supplémentaire entre des lignes électriques entre le contacteur (4) et l'électronique de puissance (7) est surveillée par le dispositif de surveillance d'isolation (3).

8. Dispositif de charge (1) destiné à charger un véhicule électrique ou hybride,
le dispositif de charge (1) comprenant un contacteur (4), un câble de charge (5), un dispositif de surveillance d'isolation (3) et une électronique de puissance (7), **caractérisé en ce que** le dispositif de charge est configuré pour effectuer un procédé selon l'une quelconque des revendications précédentes 1 à 7, et **en ce que** le câble de charge (5) est raccordé à des premiers raccordements (3.1) du dispositif de surveillance d'isolation (3), dans lequel des conducteurs électriques entre le contacteur (4) et l'électronique de puissance (7) du dispositif de charge (1) sont raccordés à des deuxièmes raccordements (3.2) du dispositif de surveillance d'isolation (3).

9. Dispositif de charge (1) selon la revendication 8, dans lequel le dispositif de surveillance d'isolation (3) du dispositif de charge (1) est raccordé entre le contacteur (4) et le câble de charge (5) du dispositif de charge (1), dans lequel le dispositif de surveillance d'isolation (3) est également raccordé entre le contacteur (4) et l'électronique de-puissance (7) du dispositif de charge (1).
